# EUROPEAN PATENT APPLICATION

(11) **EP 1 146 556 A1**
(43) Date of publication of application: **17.10.2001**
(21) Application number: 00309577.5
(22) Date of filing: 30.10.2000
(51) Int. Cl.: H01L 21/8242, H01L 21/8239, H01L 27/108

(54) **A process for fabricating an integrated ciruit that has embedded dram and logic devices**

(30) Priority: 07.04.2000 US 544234
(71) Applicant: LUCENT TECHNOLOGIES INC., Murray Hill, New Jersey 07974-0636 (US)
(72) Inventor: Diodato, Philip W., Asbury, New Jersey 08802 (US); Liu, Chun-Ting, Berkeley Heights, New Jersey 07922 (US)
(74) Representative: Williams, David John

(57) **Abstract**

A process for forming an integrated circuit having a logic device and an embedded DRAM device is disclosed. In the process a first device region (100) is electrically isolated from a second device region (101). Impurities are implanted into the first region of the semiconductor substrate to form a logic device region. Impurities are implanted into the second device region to form a DRAM device region. Gate electrodes (121) are formed for the logic and DRAM devices. A mask (130) is then formed on substrate. The mask is configured to cover the DRAM device region and have an opening through which is exposed at least a portion of the logic device region. Impurities are then implanted into the logic device region exposed through the mask to form source and drain extensions (135) for the logic devices. The mask is then removed from the substrate. Dielectric spacers adjacent to the gate electrode are then formed. Impurities are implanted into the substrate to form a device source and a device drain in the logic device region and in the DRAM region.

## Description

### BACKGROUND OF THE INVENTION

### Technical Field

The present invention is a process for fabricating an integrated circuit and, more particularly, an integrated circuit with embedded DRAM devices and logic devices.

### Art Background

Application specific integrated circuits (ASIC), such as system-on-a-chip products, require both embedded dynamic random access memory (DRAM) cells and logic circuits on a single chip. This integration improves performance by decreasing undesirable delays that occur between memory devices, located on one semiconductor chip, and logic devices located on another semiconductor chip. However, the performance requirements for the devices in the DRAM cells are completely different from the performance requirements for the devices in the logic circuits. Different performance requirements for these devices have made it difficult to integrate the fabrication sequence of the devices in the DRAM cells with the fabrication sequence of the logic devices.

For example, while both the devices in the DRAM cells and the logic devices are MOSFET (metal-oxide-semiconductor field effect transistor) devices, the logic MOSFET devices are required to have a high (about 0.75 mA/µm or higher) current drive in the on state. The trade off for this high current drive is a high leakage current in the off state. Consequently, the control for the logic MOSFET devices is not very strict (about 1 nA/device at 25°C and greater than 1 nA/device at 125°C). Conversely, the leakage of the MOSFET DRAM devices must be strictly controlled (e.g., less than 160 fA/cell at 125°C) in order to achieve the requisite data retention time.

Consequently, the logic MOSFET devices require high on current (which comes with high off current) while the DRAM devices require extremely low off current (which requires low on current). This requires a different channel doping profile for the logic MOSFET devices than for the DRAM devices. Fabricating devices with different dopant profiles on a single substrate requires separate processing steps associated with each dopant profile. For example, one ion implantation step is used to implant dopants for the logic MOSFET devices and a separate ion implantation step is used to implant dopants for the DRAM devices. In addition to separate implantation steps, fabricating devices with different dopant profiles requires that the recipes and conditions for these implant steps also be different. Additional lithography steps are also added. When different process steps and conditions are required to fabricate different devices on a single substrate, this adds to the fabrication cost.

One process for fabricating logic devices and DRAM devices is described in U.S. Patent No. 5,858,831 to Sung. The stated objective of that process is to form a thin gate insulator for the high performance CMOS (complementary metal-oxide-semiconductor) logic devices while a thicker gate insulator is used for the embedded DRAM devices. The process for forming a thick gate dielectric layer on one region of the substrate (the DRAM device region) and a thin dielectric layer on the other region of the substrate (the logic device region) is selective and therefore more complicated than forming an integrated circuit in which the gate oxide thickness for all devices is the same.

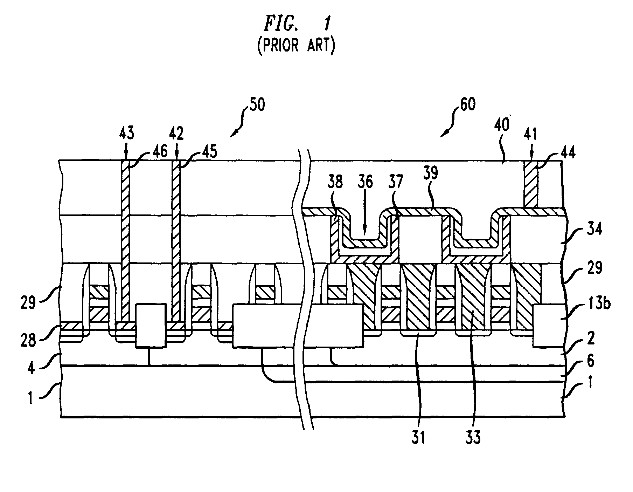

Another drawback of current processes for forming both DRAM and logic devices on a single chip is the sequence for forming the bitline and the capacitor for the DRAM devices and the interconnects for the logic devices. The problem is illustrated with reference to FIG. 1. After the logic MOSFET devices are formed in region 50 and the DRAM MOSFET devices are formed in region 60 polycrystalline silicon (polysilicon hereinafter) plugs 33 are formed to contact the n-type contact regions 31 of the DRAM devices. A thick layer of oxide 34 is then formed over both the logic 50 and DRAM regions. Openings 36 are formed in the DRAM region of oxide layer 34 to accommodate the capacitor structure (polysilicon layer 37, the capacitor dielectric layer 38 and metal layer 39 (either metal of doped polysilicon) formed therein. A silicon dioxide layer 40 is then formed over both the logic device region 50 and the DRAM device region 60. A contact hole 41 is formed in layer 40 through which the capacitor structure in DRAM region 60 is exposed. Via and contact holes 42 and 43 are formed in logic region 50, through which the source and drain regions of the logic devices are exposed. Metal contacts 45 and 46 are formed in contact holes 42 and 43, respectively.

In the above-described process, the polysilicon plugs 33 and capacitor structure are formed in the DRAM region before the metal contacts 45 and 46 are formed in the logic region. Because the metal contacts are formed last, the contact holes for these metal contacts must be formed through the silicon dioxide layers 29, 34 and 40 that were formed to accommodate the capacitor and plug formation in the DRAM region. Consequently, the contact holes for the metal contacts 45 and 46 have a very high aspect ratio (ratio of height to width). Contact holes with very high aspect ratios are difficult to fabricate.

Also, the fabrication of the polycrystalline plugs is itself problematic. First, the process for forming the doped, polycrystalline plugs is a multi-step, and therefore costly, fabrication sequence. Second, the thermal cycles required to deposit the polycrystalline plugs and distribute the dopant therein also modify the dopant profiles in the silicon substrate, including the dopant profiles in the channel of the logic devices.

Accordingly, more efficient and economical methods for fabricating both logic devices and DRAM devices on a single chip are desired.

### SUMMARY OF THE INVENTION

The present invention is directed to process for fabricating high performance MOSFET logic devices and embedded DRAM memory devices on a single semiconductor chip. The present process utilizes fewer photolithographic masking steps to fabricate such devices, compared to prior art processes. The present process also produces MOSFET and DRAM devices that meet their respective performance requirements without requiring the gate dielectric of the MOSFET devices to have a different thickness than the gate dielectric of the DRAM devices.

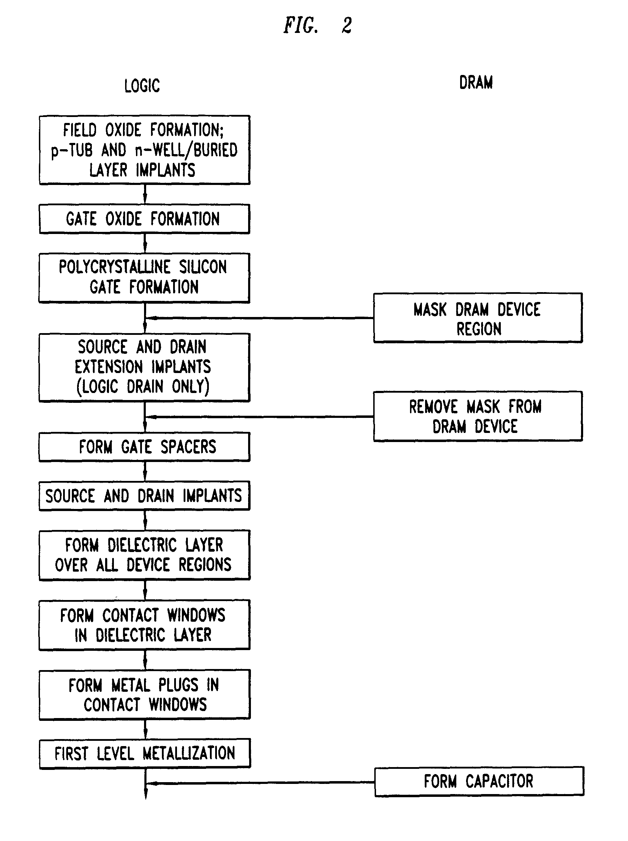

The process of the present invention is described generally with reference to the flow chart in FIG. 2. FIG. 2 illustrates the process flow for fabricating the MOSFET logic devices as the dominant process flow. The steps listed in the DRAM column are the additional steps in the process flow required to accommodate the fabrication of the DRAM devices.

The process of the present invention is advantageous because the fabrication of the logic MOSFET devices is completely integrated with the fabrication of the DRAM devices up through the formation of the contact plugs. That is, separate steps that are used only for fabricating one of either the logic MOSFET device or the DRAM device are not required. The process of the present invention is also advantageous because it does not require that the DRAM device contact plugs be polysilicon. Polysilicon plugs are not required because the doping profiles of the DRAM devices are such that metal plugs can be used. In prior art processes, the DRAM source and drain have a shallower dopant profile than the logic source and drain. Consequently, polysilicon plugs were required to contact the source and drain because metal plugs would lead to unacceptably high junction leakage in such dopant profiles. The process of the present invention produces DRAM devices with a deep source/drain dopant profile that is the same as the deep source/drain dopant profile in the logic devices.

The logic MOSFET devices are either n-channel only, p-channel only or, in most cases, both n-channel and p-channel devices. Logic circuits that have both n-channel and p-channel devices are known as complementary MOS (CMOS) devices. The DRAM devices are either n-channel or p-channel. It is advantageous, but not required, for at least some of the logic devices to be the same channel type as the DRAM devices. That is, if the logic devices are n-channel only, then it is advantageous if the DRAM devices are also n-channel. Of course, if the logic devices are CMOS, then this advantage is achieved intrinsically. Specifically, since CMOS devices have both n-channel and p-channel devices, at least some of the logic devices are the same channel type as the DRAM devices, irrespective of whether the DRAM devices are n-channel devices or p-channel devices.

The present invention is described in terms of fabricating an n-channel logic MOSFET device and an n-channel DRAM device on a single substrate. One skilled in the art is able to adapt the exemplary process flow to fabricate any combination of n-channel and/or p-channel MOSFET devices and n-channel or p-channel DRAM devices on a single substrate. For example, one skilled in the art will readily appreciate how to modify the exemplary process flow to fabricate CMOS logic devices and DRAM devices on a single substrate. Such modifications are readily made by one skilled in the art.

In the process of the present invention, field oxide regions are formed. It is advantageous, but not required, for the field oxide regions to be formed using a standard shallow trench isolation (STI) process. At this stage in the process, the tub implants and the DRAM deep well/buried layer implants are also performed. The process flow for field oxide formation and tub and deep well/buried layer implants is exemplary. One skilled in the art is aware that there are a variety of process sequences suitable for fabricating these aspects of the device. In this exemplary process flow the tubs are p-doped and the buried layer is n-doped. The p-tubs, n-shallow well and buried n-layer are formed by implanting dopants into the substrate. Materials and conditions for implanting dopants into semiconductor substrates are well known to one skilled in the art and are not described in detail herein.

A gate dielectric layer of silicon dioxide (i.e. the gate oxide) is then formed on the doped, semiconductor substrate. The gate oxide layer is the same thickness in the logic MOSFET region and the DRAM region. Typically, the thickness of the gate oxide is about 1 nm to about 10 nm. Materials and conditions for forming the thin layer of gate oxide are well known to one skilled in the art and are not described in detail herein.

The gates of the MOSFET and DRAM devices are then formed. The gates are formed using conventional processes. For example, a layer of polysilicon is first formed over the substrate. The polysilicon layer is doped. Conventional expedients for introducing dopant into polysilicon are contemplated as suitable. Such expedients are well known to one skilled in the art and are not discussed in detail herein. The doped polysilicon layer is either doped in situ while it is formed or dopant is implanted into a previously formed polysilicon layer. Alternatively, the polysilicon layer is doped using a furnace doping technique. The gates are then lithographically defined in the polysilicon layer.

Ion implantation is then performed selectively to form the source and drain extensions of the MOSFET logic devices. The DRAM devices are masked during the implant for the n-channel MOSFET source/drain extensions. Consequently, in the context of the present invention, selective formation of the source/drain extensions means that these extensions are formed for the logic devices but not for the DRAM devices. In the embodiments of the present invention wherein the logic devices are CMOS, no additional lithography is required to mask the DRAM devices. This is because, in CMOS device fabrication, the n-channel devices (and the DRAM devices in the present invention) are masked during the implant of the source/drain extensions for the p-channel devices. The portion of the mask over the DRAM devices that is formed in the process of the present invention is simply a natural extension of the mask of the n-channel devices. No additional lithography is needed to define the mask over the DRAM devices. Similarly, the p-channel devices and DRAM devices are masked during the implant for the source/drain extensions of the n-channel logic devices. The polycrystalline gate masks, and therefore defines, the channel region of the devices during the implant.

Dielectric spacers (i.e. spacers made of an electrically insulating materials such as silicon dioxide, silicon nitride or a combination of the two) are then formed by first depositing a layer of dielectric over the silicon substrate. The dielectric layer is then etched using an anisotropic etch expedient (e.g. a plasma etch) to form spacers adjacent to the gates in both the MOSFET logic region and the DRAM region. Materials and conditions for forming dielectric spacers are conventional and not described in detail herein. The width of the dielectric layer is selected to provide a spacer of a desired width (i.e. the spacer width is the portion of the underlying substrate covered by the spacer in the direction of the device channel). The spacers and the polycrystalline gate serve as a mask for the subsequent source and drain implants. Consequently, the thickness of the dielectric layer is selected to provide spacers that, in turn (and in combination with the gates), define the source and drain regions for the devices.

After the spacers are formed, dopants are implanted into the substrate to form the source and drain regions therein. Again, the materials and conditions for such implants are a matter of design choice and are well known to one skilled in the art. As a result the materials and conditions for the implants are not discussed in detail herein. As a result of this implant, and the fact that source and drain extensions were not formed in the DRAM device, the channel length (the distance between the source and drain in the direction along the device channel) of the DRAM devices extends beyond the gate length (the distance under the gate in the direction of the channel).

A first layer of dielectric material is then formed over the devices. The thickness of the dielectric layer is selected to electrically isolate the underlying devices from the conductive metallization formed on top of the dielectric layer. The specific thickness is largely a matter of design choice. However, the thinner the dielectric layer, the easier it will be to form the contact windows to the sources and drains of the devices. This is due to the fact that the aspect ratio of the contact windows increases with increasing dielectric layer thickness. The higher the aspect ratio of the contact window, the more difficult it is to fabricate.

After the contact windows are formed, conductive plugs (i.e. either metal or polysilicon doped to have conductivity comparable to metal) are formed in the contact windows. After the conductive plugs are formed, the first level of metallization is formed on the dielectric layer. It is advantageous if the plugs are metal. Metal plugs, in contrast with doped polysilicon plugs, do not require subsequent thermal processing after they are formed. Doped polycrystalline plugs must be heated to activate the dopants therein. As previously noted, metal plugs were not suitable as DRAM contacts in prior art processes. The metal plugs were not suitable because the source/drain dopant profiles for prior art DRAM devices were such that the junction leakage was too great if metal plugs were used.

A second layer of dielectric material is formed over the first level of metallization. Contact windows are formed to the first level of metallization, and conductive plugs are formed in the contact windows. A second level of metallization is then formed over the first layer of dielectric material. The DRAM capacitors are formed on the second dielectric layer.

### BRIEF DESCRIPTION OF THE DRAWINGS

FIG. 1 is a schematic cross-section of a CMOS device and a DRAM device on a single semiconductor chip made using a prior art process.

FIG. 2 is a flow chart for the process of the present invention.

FIGS. 3-8 illustrate, schematically in device cross-section, certain aspects of the process to fabricate MOSFET logic devices and DRAM devices on a single semiconductor substrate.

### DETAILED DESCRIPTION

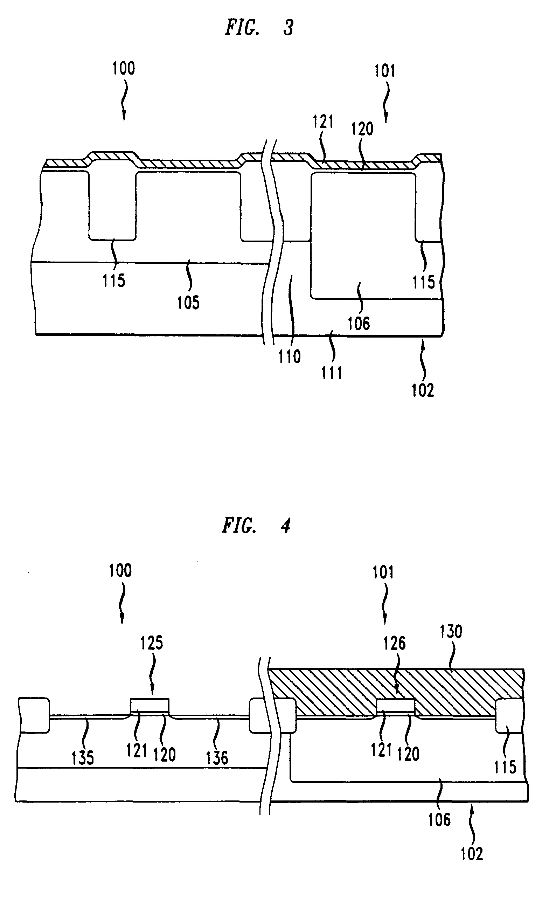

The fabrication process used to create high performance logic regions and low cost memory regions will be described with reference to FIGS. 3-8. The DRAM device described herein is an n-channel transistor. If desired the process of the present invention can be used to fabricate p-channel DRAM transistors. This is accomplished by forming a n-tub region, in the p-type semiconductor substrate, and creating p-type heavily doped source and drain regions.

Referring to FIG. 3, shallow trench isolation regions 115 are formed by depositing a layer of pad silicon dioxide (SiO₂) (not shown) that has a thickness of about 10 nm to about 50 nm on the surface of silicon substrate 102. A layer of silicon nitride (Si₃N₄) (not shown) that has a thickness of about 100 nm to 300 nm is formed of over the pad oxide layer.

A patterned photoresist mask (not shown) is then formed on the resulting structure using conventional photolithography. Trenches having a width of about 100 nm to about 1 µm are etched in the portions of the resulting structure that are exposed through openings in the photoresist mask. The trenches extend to a depth of about 100 nm to about 500 nm in the silicon substrate 102. An anisotropic reactive ion etch (RIE) is used to create the shallow trenches. A thermal oxidation step is then performed to form a thin (5 nm to 50 nm) layer thermal oxide in the trench. A thick (500 nm to 1 µm) oxide layer is then deposited over the entire structure. The thick oxide is deposited using a high-density plasma deposition.

A chemical mechanical polishing procedure is used to polish the thick oxide layer back to the silicon nitride layer. This is followed by a wet etch to remove silicon nitride and the underlying silicon dioxide. The resulting shallow trench isolation regions 115 are depicted in FIG. 3.

A sacrificial oxide layer (not shown) having a thickness of 5 nm to 50 nm is then thermally grown on the resulting structure. Then, p-tub regions 105 and 106 are formed in the respective MOSFET logic device region 100 and the DRAM device region 101 of semiconductor substrate 102. After the p-tubs 105 and 106 are formed, an n-well region 110 and a buried n-layer 111 are formed to isolate the DRAM p-tub 106 from the MOSFET p-tub 105. The p-tubs, n-well and buried n-layer are formed by implanting dopants into the substrate. Materials and conditions for implanting dopants into semiconductor substrates are well known to one skilled in the art and are not described in detail herein.

After the implants, the sacrificial oxide is removed. A thin (about 4 nm to about 7 nm) layer of silicon dioxide 120 is formed on the surface of the substrate, 102 by thermal oxidation. This is referred to as the gate oxide layer. A layer or layers of material are then deposited from which the gate electrodes are formed. Examples of suitable materials include polysilicon or metal silicide (e.g. tungsten silicide). In this embodiment, where the gate electrode is polysilicon, an undoped layer of polysilicon 121 is next deposited using low pressure chemical vapor deposition, (LPCVD) to a thickness of about 50 to about 300 nm. The polysilicon layer is doped using conventional processes. Typically, the polysilicon layer is doped using a furnace doping technique. In a furnace doping technique, a dopant source layer is deposited over the polysilicon layer. The resulting structure is then heated to drive the dopants into the underlying polysilicon. Other conventional expedients (i.e. in-situ doping, ion implantation, etc.) are also contemplated as suitable. The dopant is selected according to the gate type (i.e. n-type dopants such as phosphorus or arsenic for an n-channel device).

If the logic devices are CMOS, two separate lithography steps are used to dope the polysilicon. One lithographic step is used to mask the p-channel devices (logic, DRAM or both, as appropriate) when polycrystalline layer 121 in the n-channel device region 100 (shown in FIG. 3) is doped. The second lithography is used to mask the n-channel device region (logic, DRAM or both, as appropriate) when the polycrystalline layer 121 in the p-channel device region is doped.

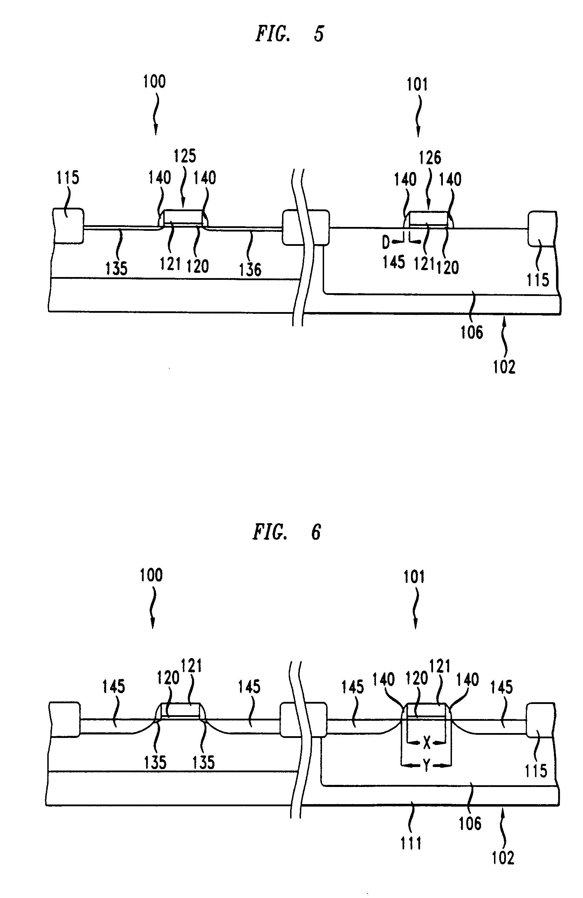

Referring to FIG. 4, the gates are formed for the MOSFET and DRAM devices. The gate stacks are defined using conventional lithographic techniques. Specifically, a layer of energy sensitive material is formed over the structure illustrated in FIG. 3. An image of a pattern that defines the gate stacks is introduced into the energy sensitive material. The image is developed into a patterned etch mask. After the etch mask is formed, the portion of the doped polysilicon layer 121 exposed through the mask is etched. A plasma etch is used to pattern the underlying stack of polysilicon layer 121/gate oxide layer 120. Cl₂ is an example of a suitable etchant. After the etch, the remaining portion of the etch mask is removed and the gate stacks 125 and 126 remain.

A mask 130 is then formed over the DRAM region to shield the DRAM region from a subsequent ion implantation step to form the source 135 and drain 136 extensions for the n-channel devices in logic region 100. N-type dopant is then implanted into the logic region 100 of the substrate 102. The gate stack 125 masks the channel region of the MOSFET device from the implant and defines the implant region. After the source and drain extension implant, the mask 130 is removed from the DRAM region of the substrate. Since these source/drain extensions are formed for the logic devices only, this step is referred to as selective formation of the source/drain extensions.

As previously noted, if the logic devices are CMOS devices, then two masking steps are required. A first mask is required for the extension implant of the n-channel devices. A second mask is required for the extension implant of the p-channel devices. These masks also mask the DRAM region during the implants. Thus the mask over the DRAM region I is a natural extension of the mask formed over the logic region. As such, no additional lithography is required to form the mask over the DRAM region for the extension implants of the CMOS devices. After the extension implants, the mask 130 is removed.

Referring to FIG. 5, dielectric spacers (i.e. spacers made of an electrically insulating materials such as silicon dioxide, silicon nitride or a combination thereof) are then formed by depositing the dielectric layer or layers over the silicon substrate 102. The layer or layers are deposited using either PECVD or LPCVD. The layer or layers are then etched using an anisotropic etch expedient (e.g. a plasma etch) to form spacers 140 adjacent to the gates 125, 126 in the respective MOSFET logic 100 and DRAM regions 101. The spacers 140 are illustrated in FIG. 5. Although the dielectric spacers 140 can be formed from two layers of dielectric materials (i.e., silicon dioxide followed by and silicon nitride) the spacers 140 are illustrated as simply one layer being formed from two separate layers of material. Materials and conditions for forming dielectric spacers are conventional and not described in detail herein. The thickness of the dielectric layer is selected to provide a spacer of a desired width, D. The spacers and the polycrystalline gate serve as a mask for the subsequent source and drain implants. Consequently, D is selected to provide spacers that, in turn and in combination with the gates, define the deep source and drain regions for the devices.

After the spacers 140 are formed, n-type dopants (e.g. arsenic or phosphorus) are implanted into the substrate 102 to form the deep source and drain regions 145 therein. The deep source and drain regions 145 are illustrated in FIG. 6. Again, the materials and conditions for such implants are a matter of design choice and are well known to one skilled in the art. As a result the materials and conditions for the implants are not discussed in detail herein. Exemplary conditions for a suitable arsenic or phosphorus implant are energies in the range of about 10 KeV to about 100 KeV at a dose of about lx 10¹⁵ atoms/cm² to about 5 x 10¹⁸ atoms/cm². As a result of this implant, and the fact that source and drain extensions 135 were not formed in the DRAM device, the channel length Y of the DRAM devices extends beyond the gate length X.

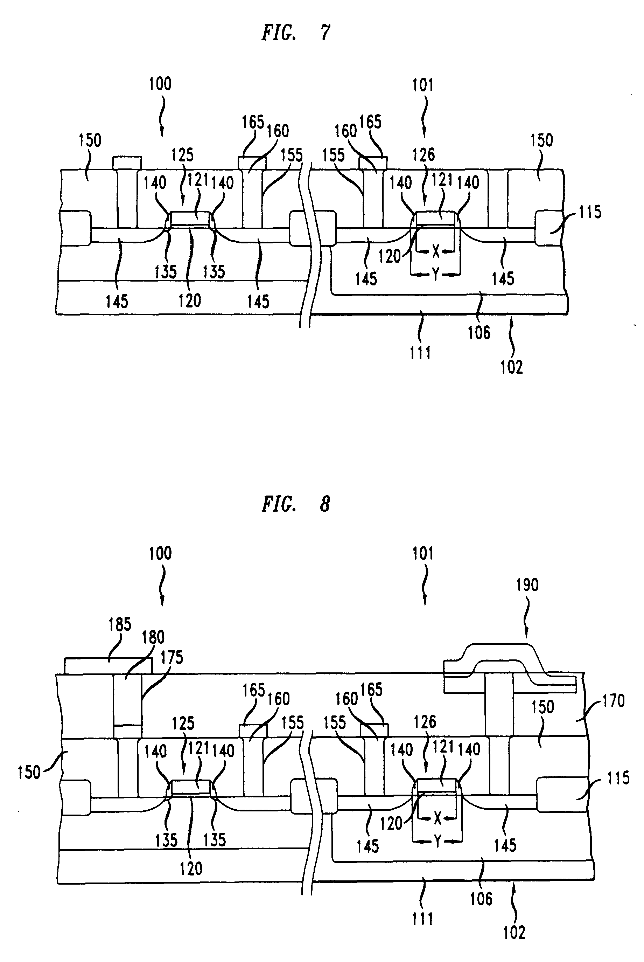

Referring to FIG. 7, a first layer of electrically insulating material 150, e.g. silicon oxide, is then formed over the structure depicted in FIG.6. The silicon oxide layer 150 is deposited using PECVD of LPCVD. The thickness of the silicon oxide layer 150 is 200 nm to 1000 nm. The thickness of the silicon oxide layer 150 is selected to electrically isolate the underlying devices from the conductive metallization 165 formed on top of the silicon dioxide layer 150. The specific thickness is largely a matter of design choice. However, the thinner the silicon dioxide layer 150, the easier it will be to form the contact windows 155 to the sources and drains 145 in both the MOSFET logic region 100 and the DRAM device region 100. This is due to the fact that the aspect ratio of the contact windows increases with increasing dielectric layer thickness. The higher the aspect ratio of the contact window 155, the more difficult it is to fabricate.

After the contact windows 155 are formed, conductive plugs 160 (e.g. tungsten plugs) are formed in the contact windows 155. The tungsten plugs are formed by depositing a thin layer of titanium onto silicon oxide layer 150. A layer of titanium nitride is formed over the titanium layer. Both layers are thin so that the layers do not fill contact windows 155. A layer of tungsten is then deposited over the titanium/titanium nitride layer. The metal layers are then polished back to the surface of silicon dioxide layer 150. The remaining metal is the metal 160 in contact window 155. The control windows 155 all have the same height, which is defined by the thickness of silicon dioxide layer 150. Thus, the aspect ratio for the contact windows is the same. Referring to the prior art structure in Fig. 1, the contact windows 44, 45 and 46 do not have uniform height. The aspect ratio for the contact windows are therefore not uniform for the device illustrated in Fig. 1.

After the conductive plugs 160 are formed, the first level of metallization 165 is formed on the silicon dioxide layer 155. The first level of metallization is formed by depositing a layer of metal on silicon dioxide layer 150 and then patterning the layer to form metallization 165. The metal layer is patterned using conventional lithographic techniques well known to one skilled in the art and not discussed in detail herein.

Referring to FIG. 8, another layer of silicon dioxide 170 is formed on silicon dioxide layer 150 and the first level of metallization 165 formed thereon. Contact windows 175 are formed to the first level of metallization 165, and tungsten plugs 180 are formed in the contact windows 175 as previously described. A second level of metallization 185 is then formed on the silicon dioxide layer 170. The DRAM capacitors 190 are formed on the silicon dioxide layer 170 in the DRAM region 101. The capacitor 190 is formed using conventional materials and processes well known to one skilled in the art and not discussed in detail herein.

While this invention has been described with reference to certain illustrative embodiments, one skilled in the art will appreciate that modifications to the embodiments may be made without departure from the spirit and scope of the invention.

## Claims

1. A process for fabricating an integrated circuit with an embedded DRAM device comprising:
electrically isolating a first region of a semiconductor substrate from a second region in the semiconductor substrate;
introducing dopants into the first region of the semiconductor substrate to form a logic device region and introducing dopants into the second region of the semiconductor substrate to form a DRAM device region;
forming a gate electrode for a logic device in the logic device region and forming a gate electrode for a DRAM device in the DRAM region;
forming a mask on the substrate, wherein the mask covers the DRAM device region and wherein at least a portion of the logic device region is exposed through an opening in the mask;
forming source and drain extensions selectively for the logic device exposed through the mask by implanting dopants into the logic device region exposed through the mask;
removing the mask from the substrate;
forming dielectric spacers adjacent to the gate electrode; and
introducing dopants into the substrate to form a device source and a device drain in the logic device region and in the DRAM region.

2. The process of claim 1 further comprising:
forming a first insulating dielectric layer on the substrate after the device source and device drain are formed for the logic device and the DRAM device;
forming a plurality of contact windows in the first insulating dielectric layer wherein a first contact window communicates with the source of the logic device, a second contact window communicates with the drain of the logic device, a third contact window communicates with the source of the DRAM device and a fourth contact window communicates with the drain of the DRAM device.

3. The process of claim 2 further comprising:
forming conductive plugs in the first, second, third and fourth contact windows.

4. The process of claim 3 wherein the conductive plugs are formed by:
depositing a layer of metal on the first insulating dielectric layer with the windows formed therein, wherein the thickness of the deposited metal is sufficient to fill the windows with metal; and
removing metal formed on the dielectric layer.

5. The process of claim 4 wherein the metal is comprised of tungsten.

6. The process of the claim 1 wherein the logic device is selected from the group consisting of an n-channel device, a p-channel device and combinations thereof and the DRAM device is selected from the group consisting of an n-channel device and a p-channel device.

7. The process of claim 3 further comprising forming a second insulating dielectric layer over the first insulating dielectric layer;
forming a contact window therein that communicates with the conductive plug that communicates with the drain of the DRAM device;
forming a conductive plug in the contact window; and
forming a capacitor in contact with the conductive plug.

8. The process of claim 7 wherein the conductive plug is metal.

9. An integrated circuit device comprising:
a logic device and a DRAM device formed on a unitary, semiconductor substrate wherein the logic device and the DRAM device are transistors having a source, a drain, and a gate electrode with dielectric spacers adjacent to the gate electrode, wherein the DRAM device has a channel with a length associated therewith and the logic device has a channel with a length associated therewith and the DRAM device channel length is longer than the logic device channel length and wherein the DRAM device has a gate with an associated length and the DRAM device channel length is longer than the DRAM device gate length.

10. The integrated circuit device of claim 9 wherein the channel length of the logic device is defined by the gate electrode and the channel length of the DRAM device is defined by the gate electrode and the dielectric spacers adjacent thereto.

11. The integrated circuit device of claim 10 wherein a first layer of insulating dielectric material is formed over the logic device and the DRAM device wherein the insulating dielectric layer has a plurality of conductive plugs therein that communicate with the underlying logic device and the underlying DRAM device and wherein the conductive plugs that communicate with the source and drain of the DRAM device and the conductive plugs that communicate with the source and drain of the logic device are the same material.

12. The integrated circuit device of claim 11 wherein the conductive plugs are a metal material.

13. The integrated circuit device of claim 12 wherein the metal conductive plugs are comprised of tungsten.
